# FASCICULE DE BREVET EUROPEEN

(11) **EP 0 676 823 B1**
(45) Date de publication et mention de la délivrance du brevet: **25.11.1998**
(21) Numéro de dépôt: 95400748.0
(22) Date de dépôt: 04.04.1995
(51) Int. Cl.: H01P 1/26, G01R 1/20, G01R 31/28

(54) **Charge de puissance à refroidissement par air et antenne fictive**
Luftgekühlte Last und Scheinantenne
Air cooled power load and fictive antenna

(30) Priorité: 08.04.1994 FR 9404169
(43) Date de publication de la demande: 11.10.1995
(73) Titulaire: THOMCAST, 78700 Conflans-Sainte-Honorine (FR)
(72) Inventeur: Wolk, Ivan, F-92402 Courbevoie Cedex (FR)
(74) Mandataire: Courtellemont, Alain

(56) Documents cités:
- EP-A- 0 117 778
- GB-A- 395 363
- GB-A- 1 134 091
- US-A- 1 563 363
- US-A- 2 825 874
- US-A- 5 113 171

## Description

La présente invention se rapporte à une charge de puissance à refroidissement par air qui est conçue, en particulier mais pas uniquement, pour être utilisée comme antenne fictive en radioémission.

L'utilisation de résistances de puissance en radiofréquences, en particulier dans le domaine des ondes moyennes s'impose par exemple, pour effectuer des tests de fonctionnement électrique ainsi que des mesures de performances avec un émetteur de radiodiffusion. Pour ce faire la charge, souvent appelée antenne fictive, doit posséder une grande stabilité d'impédance en température et en fréquences pour ne pas engendrer de fluctuations du fonctionnement de l'émetteur.

En radiofréquences il est connu de réaliser des charges à l'aide d'éléments résistifs refroidis par eau; certaines de ces charges présentent une bonne stabilité résistive jusqu'à quelques mégahertz, mais ont un inconvénient majeur : elles nécessitent un circuit de refroidissement par eau, or un tel circuit est coûteux et peut être très difficile à mettre en oeuvre.

D'autres charges ont leur résistance qui est réalisée à l'aide d'une portion de circuit dans laquelle circule de l'eau sodée; certaines de ces charges sont munies de pistons d'accord pour permettre un réglage en température. De telles charges sont utilisables pour de fortes puissances et présentent une bonne stabilité en fréquences mais ont l'inconvénient de nécessiter deux circuits d'eau : le circuit d'eau sodée et, en plus, un circuit d'eau ordinaire conçu pour refroidir le circuit d'eau sodée.

Il est à noter qu'il est d'autre part connu, par exemple du brevet GB 395 363, de réaliser des résistances selon la technique dite du métal déployé (expanded metal dans la littérature anglo-saxonne) qui consiste à effectuer, dans une bande métallique, une multitude de découpes parallèles, sans enlèvement de matière mais en écartant les bords des découpes de manière à constituer une sorte de grillage. De telles résistances, mises bout à bout, sont employées dans des domaines comme la traction électrique, le chauffage électrique industrielle, le freinage électrique de puissance dans certains trains : les charges ainsi constituées ont une bonne stabilité en température mais sont peu stables en fréquence et ne peuvent donc être utilisées comme antennes fictives dans les cas où une large bande de fréquences de fonctionnement est désirée. A ce sujet il faut noter que les nouvelles sources de puissance en radiofréquences, en technologie MOSFET, sont très sensibles aux variations de charge en raison de leur très faible impédance interne dynamique et que, de ce fait, la stabilité de la charge doit être assurée au delà des fréquences de travail, généralement jusqu'à l'harmonique 3 de la fréquence de travail la plus élevée.

La présente invention a pour but de proposer une charge de puissance à refroidissement par air ayant une bonne stabilité en température et en fréquence et d'un prix de revient nettement inférieur à celui des charges à circuit d'eau sodée, à réglage par pistons.

Ceci est obtenu en utilisant un assemblage de modules résistants en métal déployé montés en série, et en associant à cet assemblage une compensation en fréquence.

Selon l'invention il est proposé pour cela une charge de puissance à refroidissement par air, comportant un assemblage série de modules résistants sensiblement plans, en métal déployé, une structure support métallique et des éléments isolants pour maintenir l'assemblage, caractérisée en ce que, de manière à être utilisable en radiofréquences, elle est munie de moyens de compensation en fréquence, ces moyens de compensation comportant des liaisons capacitives pour, parmi certaines extrémités des modules, en relier chacune une à la structure support.

La présente invention sera mieux comprise et d'autres caractéristiques apparaîtront à l'aide de la description ci-après et des figures s'y rapportant qui représentent :
- la figure 1, un module résistant utilisé dans une charge selon l'invention,
- la figure 2, une partie du module résistant selon la figure 1,
- les figures 3 et 4, une charge selon l'invention, vue de face et de côté,
- la figure 5, un schéma électrique relatif à la charge selon les figures 3 et 4,
- la figure 6, une courbe représentative d'une caractéristique de la charge selon les figures 3 et 4,
- et la figure 7, des composants utilisés dans la charge selon les figures 3 et 4.

Sur les différentes figures les éléments correspondants sont désignés par les mêmes repères.

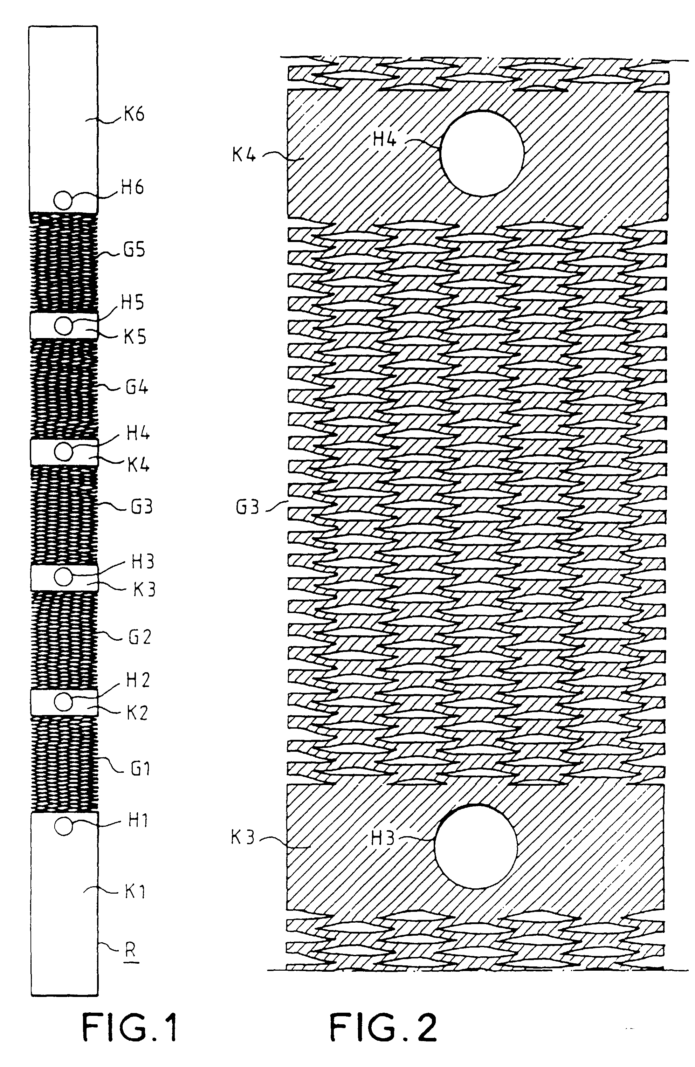

La figure 1 montre un module résistant, R, obtenu par la technique du métal déployé, à partir d'une bande métallique de 9 cm de largeur et 0,18 mm d'épaisseur. Ce module comporte, en alternance le long de la bande métallique, des portions grillagées en métal déployé, G1-G5, et des portions non grillagées, K1-K6, percées d'un trou, H1-H6. Les portions grillagées sont au nombre de cinq par module; elles ont une longueur de 13,7 cm. Les portions non grillagées K2 à K5 occupent une longueur de 2,8 cm sur la bande tandis que les portions non grillagées d'extrémité de module, K1, K6, ont une longueur de 22,5cm et constituent des languettes destinées à servir au raccordement du module. Le module résistant selon la figure 1, tel qu'il a été réalisé, présente une résistance de 1,04 ohm.

La figure 2 est une vue partielle agrandie d'une partie de la figure 1 avec, en particulier, la portion grillagée G2 et les trous H3 et H4.

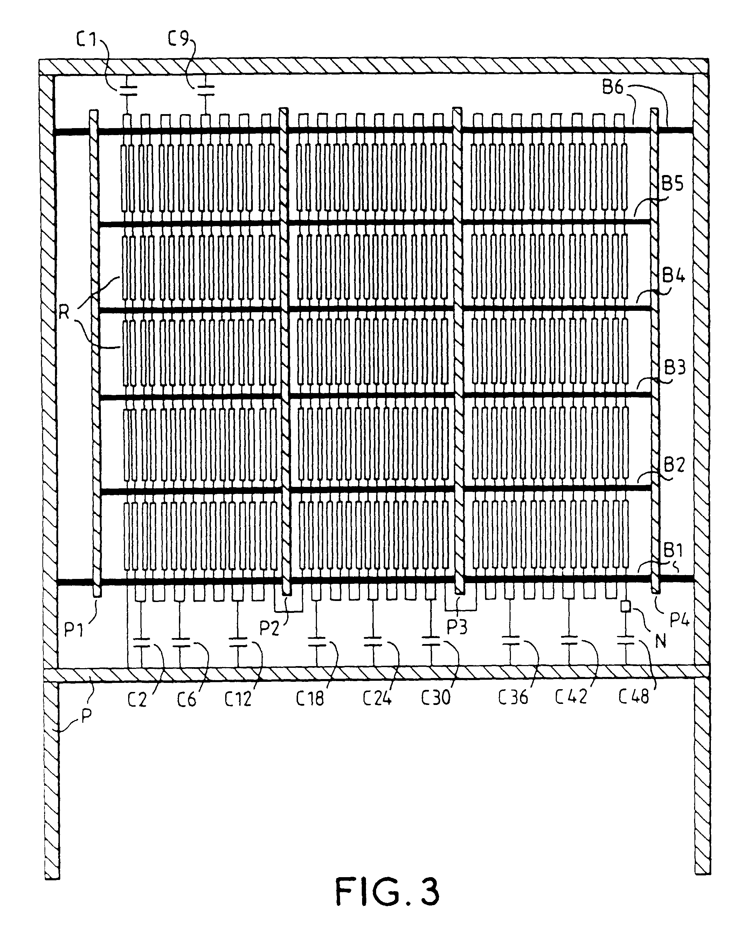

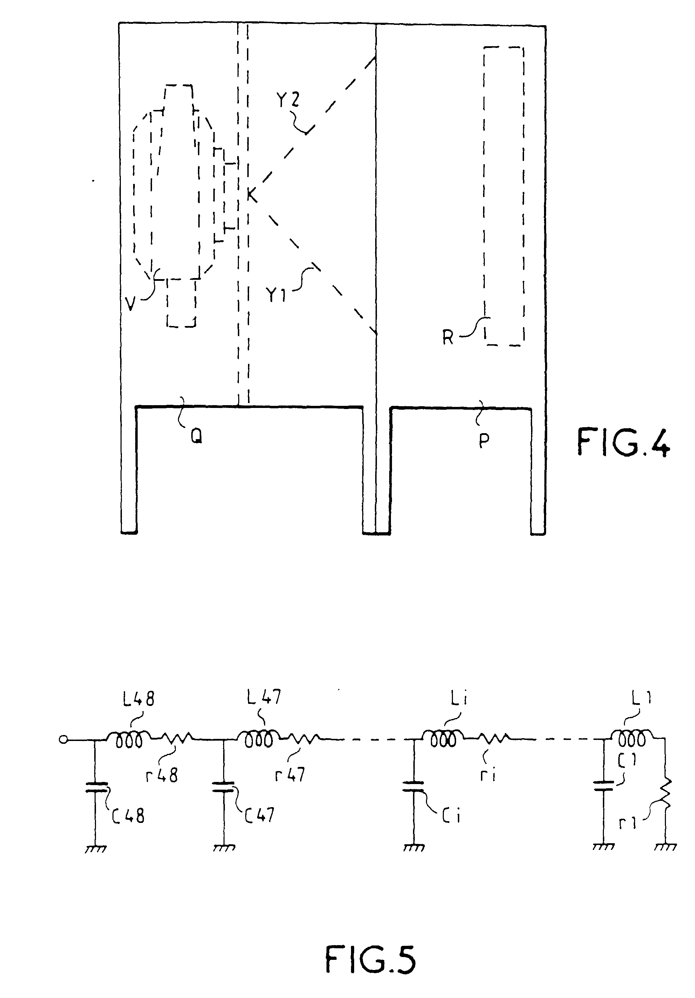

Les figures 3 et 4 sont des vues simplifiées montrant comment 48 modules selon la figure 1 sont montés en série pour constituer une charge de puissance de 50 ohms, 150 kW, destinée à être utilisée comme antenne fictive.

La figure 3 montre la charge vue de face avec les 48 modules, tels que R, montés en série dans des plans verticaux perpendiculaires au plan de la figure ; les portions grillagées des modules sont représentées par des rectangles allongés tandis que les portions non grillagées sont représentées par des traits continus. Les 48 modules sont maintenus à l'intérieur d'une armoire métallique P, sans face avant et sans face arrière mais avec, à l'intérieur, six barres isolantes horizontales B1-B6 qui passent à travers les trous des modules et quatre plaques métalliques verticales, P1-P4, parallèles aux plans des modules et, donc, perpendiculaires au plan de la figure 3. Les plaques P1-P4 séparent géographiquement les modules en trois groupes de 16 modules mais électriquement les trois groupes sont en série. Le module le plus à gauche sur la figure 3 est relié à l'armoire métallique P par une liaison M tandis que le module le plus à droite est relié à une borne d'accès, N, de la charge, symbolisée par un rectangle.

La figure 4 montre la charge vue de côté avec l'armoire métallique P et une autre armoire métallique Q, sans face avant ni face arrière, accolée à l'armoire P. Le contenu des armoires P et Q est représenté, comme vu par transparence; pour l'armoire P ce contenu a été représenté de façon schématisée par le module résistant, R, de la figure 3. L'armoire Q, quant à elle, contient un ventilateur, V, d'un débit maximum de 23 000m³/h et des plaques de déflexion Y1, Y2. Le ventilateur V aspire l'air de l'espace situé, sur la figure 3, à gauche de l'armoire Q et le souffle via les plaques Y1, Y2 sur les modules résistants tels que R.

Sur le plan électrique la charge selon les figures 3 et 4 peut être assimilée à un ensemble série de 48 quadripôles ayant chacun un condensateur, C1..Ci..C47,C48, en dérivation et une inductance, L1 ... Li ... L47, L48, et une résistance, r1 ... ri ... r47, r48 en série. Les résistances ont pour valeur 1,04 ohms comme il a été indiqué lors de la description de la figure 1. Quant aux inductances et aux condensateurs ils représenteraient, pour une charge de puissance réalisée de façon classique, des capacités et des inductances parasites ; dans la réalisation qui est décrite ici, certains de ces condensateurs, C1, C2, C6, C9, C12, C18, C24, C30, C36, C42, C48 sont en fait la somme d'une capacité parasite et d'un condensateur fixe de valeur donnée. Ces condensateurs fixes sont montés entre la paroi de l'armoire métallique P et l'extrémité de certains des modules résistants; ils sont destinés à compenser la charge dans ses fréquences d'utilisation de telle sorte qu'elle présente un taux d'ondes stationnaires ou TOS (standing-wave ratio ou SWR dans la littérature anglo-saxonne) acceptable. Pour cela, en fonction des éléments constitutifs du circuit, le TOS est calculé à l'entrée de la charge; ce calcul est effectué avec le souci d'obtenir le TOS souhaité au moyen d'un nombre minimum de condensateurs convenablement répartis ; il s'agit donc d'une optimisation et, en fait, ce n'est pas un calcul de TOS qui est effectué mais une succession de calculs de TOS, ces calculs étant relatifs à différentes répartitions de condensateurs le long de la charge résistive proprement dite, et à différentes valeurs attribuées à ces condensateurs. Dans l'exemple décrit où le TOS souhaité ne doit pas dépasser 1,15 de 0 à 1,7 MHz et ne doit pas dépasser 1,5 de 1,7 à 5MHz, ces calculs successifs ont abouti à prendre onze condensateurs répartis comme indiqué sur la figure 3 et présentant les caractéristiques suivantes :

| | | | |
|---|---|---|---|
| C1 | 100 nF , | 88 V eff , | 89 A eff |
| C2 | 24 nF , | 122 V eff , | 29 Aeff |
| C6 | 3,3 nF , | 466 V eff , | 16 A eff |
| C9 | 2,2 nF, | 726 V eff , | 16 A eff |
| C12 | 1,8 nF, | 948 V eff , | 17 A eff |
| C18 | 1,5 nF , | 1327 V eff , | 20 A eff |
| C24 | 920 pF , | 1633 V eff , | 15 A eff |
| C30 | 560 pF , | 1905 V eff , | 11 A eff |
| C36 | 330 pF , | 2171 V eff , | 7 A eff |
| C42 | 240 pF , | 2450 V eff , | 6 A eff |
| C48 | 160 pF , | 2740 V eff , | 5 A eff |

La liste ci-avant donne pour chacun des onze condensateurs la valeur de sa capacité ainsi que sa tension et son courant efficaces en régime de fonctionnement nominal; il est à noter que les valeurs de capacités sont des valeurs normalisées, les calculs ayant été faits à partir de telles valeurs.

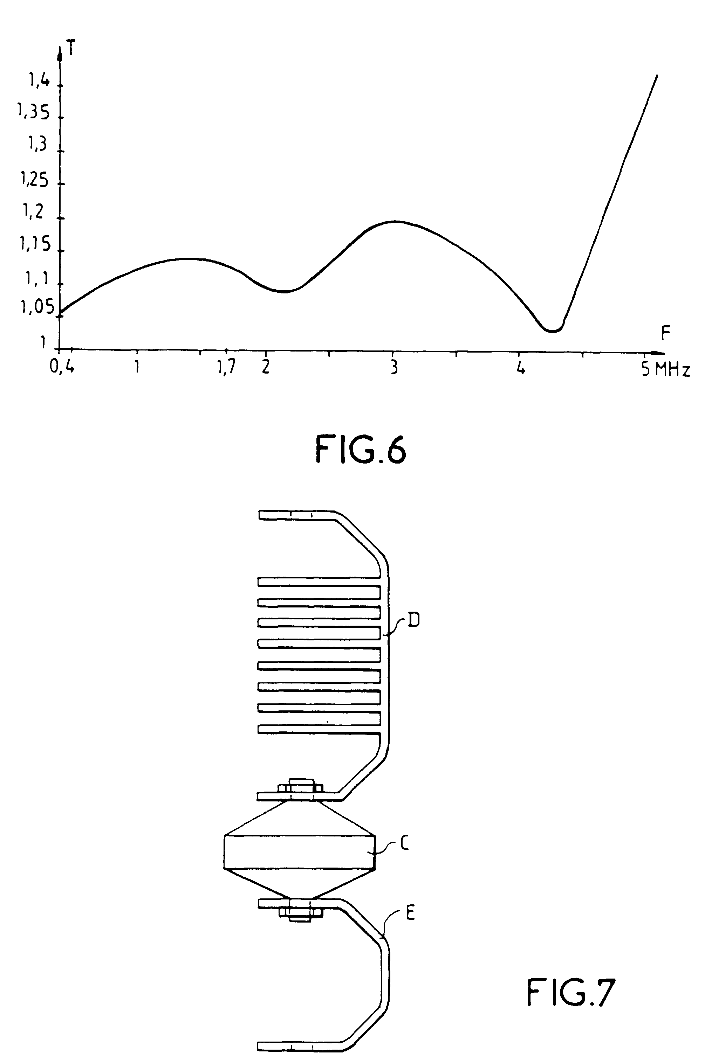

La figure 6 représente la courbe de variation du taux d'ondes stationnaires, T, en fonction de la fréquence F à l'entrée de la charge qui vient d'être décrite. Cette courbe montre que le taux d'ondes stationnaires est inférieur à 1,15 non pas simplement jusqu'à 1,7 MHz comme souhaité mais jusqu'à un peu plus de 2,5 MHz et que jusqu'à 5 MHz non seulement il ne dépasse pas 1,5 mais reste inférieur ou égal à 1,4.

La figure 7 montre, à titre d'exemple, comment monter un condensateur, C, entre la paroi de l'armoire métallique P et les modules résistants. Le condensateur C est relié aux modules résistant par un radiateur à ailettes D et est relié à la paroi de l'armoire par un étrier métallique E ; le radiateur à ailettes est destiné à assurer, entre le module résistant dont la température peut atteindre 300°C et le condensateur, un gradient de température suffisant pour éviter que le condensateur soit endommagé. Dans l'exemple représenté le condensateur est un condensateur équipé de sorties à vis ; dans le cas de condensateurs équipés de sorties par fils, par languettes ou de tout autre type de sorties, le radiateur D et l'étrier E sont adaptés aux sorties considérées de même que les raccordements entre ces pièces et les sorties du condensateur: raccordement par soudure, vissage ou autre.

La présente invention n'est pas limitée à l'exemple décrit, elle s'étend à toutes les réalisations de charges à élément résistant en métal déployé comportant un circuit de compensation en fréquence fait de condensateurs en dérivation, répartis le long de l'élément résistant; et, en particulier, l'invention s'applique à de telles réalisations même si elles ne comportent pas de ventilation forcée mais seulement un refroidissement par convection naturelle de l'air ambiant, et sont donc beaucoup plus limitées en puissance.

## Revendications

1. Charge de puissance à refroidissement par air, comportant un assemblage série de modules résistants (R) sensiblement plans, en métal déployé, une structure support métallique (P, Q, P1-P4) et des éléments isolants (B1-B6) pour maintenir l'assemblage, caractérisée en ce que, de manière à être utilisable en radiofréquences, elle est munie de moyens de compensation en fréquence, ces moyens de compensation comportant des liaisons capacitives (C1, C2, C6, C9, C12, C18, C24, C30, C36, C42, C48) pour, parmi certaines extrémités des modules, en relier chacune une à la structure support.

2. Charge selon la revendication 1, comportant des moyens de ventilation (Y, Y1, Y2) pour assurer une ventilation forcée des modules, caractérisée en ce que les moyens de compensation en fréquence sont localisés en des endroits où ils subissent eux aussi une ventilation forcée de la part des moyens de ventilation.

3. Charge selon l'une des revendications précédentes, caractérisée en ce que au moins certaines des liaisons capacitives comportent en série, en plus d'un condensateur proprement dit (C), un élément dissipateur d'énergie (D).

4. Charge selon la revendication 3, caractérisée en ce que l'élément dissipateur d'énergie est du type radiateur à ailettes et en ce que les ailettes du radiateur sont disposées dans des plans parallèles au plan dans lequel est disposé le module à l'extrémité de laquelle la liaison capacitive considérée est reliée.

5. Antenne fictive, caractérisée en ce qu'elle est constituée par une charge selon au moins l'une des revendications précédentes.

## Patentansprüche

1. Luftgekühlte Leistungslast, mit einer Serieninstallation von im wesentlichen ebenen Streckmetall-Widerstandsmodulen (R), einer metallischen Trägerstruktur (P, Q, P1-P4) und Isolierelementen (B1-B6) zur Aufrechterhaltung der Anordnung, dadurch gekennzeichnet, daß sie für ihre Verwendbarkeit bei Funkfrequenzen mit Frequenzkompensationsmitteln versehen ist, die kapazitive Verbindungen (C1, C2, C6, C9, C12, C18, C24, C30, C36, C42, C48) enthalten, um von bestimmten Enden der Module jeweils eines mit der Trägerstruktur zu verbinden.

2. Last nach Anspruch 1, die Belüftungsmittel (Y, Y1, Y2) zur Sicherstellung einer Zwangsbelüftung der Module enthält, dadurch gekennzeichnet, daß die Frequenzkompensationsmittel sich an Stellen befinden, an denen sie ebenfalls einer Zwangsbelüftung von seiten der Belüftungsmittel unterworfen werden.

3. Last nach irgendeinem vorangehenden Anspruch, dadurch gekennzeichnet, daß wenigstens bestimmte der kapazitiven Verbindungen in Serie zusätzlich zu einem eigentlichen Kondensator (C) ein Energieabführungselement (D) enthalten.

4. Last nach Anspruch 3, dadurch gekennzeichnet, daß das Energieabführungselement vom Typ Lamellenkühler ist und daß die Lamellen des Kühlers in Ebenen angeordnet sind, die zu der Ebene parallel sind, in der das Modul angeordnet ist, mit dessen Ende die betrachtete kapazitive Verbindung verbunden ist.

5. Ersatzantenne, dadurch gekennzeichnet, daß sie durch eine Last nach wenigstens einem der vorangehenden Ansprüche gebildet ist.

## Claims

1. Air-cooled power load comprising a series assembly of substantially planar resistive modules (R), made of expanded metal, a metal support structure (P, Q, P1-P4) and insulating elements (B1-B6) for holding the assembly together, characterized in that, so as to be useable at radiofrequencies, it is provided with frequency-compensation means, these compensation means comprising capacitive links (C1, C2, C6, C9, C12, C18, C24, C30, C36, C42, C48) in order for each of them to connect one end among some of the ends of the modules to the support structure.

2. Load according to Claim 1, comprising ventilation means (Y, Y1, Y2) for providing forced ventilation of the modules, characterized in that the frequency-compensation means are localized at places where they too undergo forced ventilation by the ventilation means.

3. Load according to one of the preceding claims, characterized in that at least some of the capacitive links comprise, in series, in addition to an actual capacitor (C), an energy-dissipating element (D).

4. Load according to Claim 3, characterized in that the energy-dissipating element is of the finned-radiator type and in that the fins of the radiator lie in planes parallel to the plane in which the module to the end of which the capacitive link in question is connected lies.

5. Imaginary antenna, characterized in that it consists of a load according to at least one of the preceding claims.
